# EUROPEAN PATENT APPLICATION

(11) **EP 2 172 979 A1**
(43) Date of publication of application: **07.04.2010**
(21) Application number: 08787659.5
(22) Date of filing: 26.06.2008
(51) Int. Cl.: H01L 31/0328

(54) **PHOTONIC USE OF INTERMEDIATE BAND MATERIALS BASED ON A CHALCOGENIDE-TYPE SEMICONDUCTOR**

(30) Priority: 19.07.2007 ES 200702008
(71) Applicant: Consejo Superior De Investigaciones Científicas, 28006 Madrid (ES); Universidad Politécnica de Madrid, 28040 Madrid (ES)
(72) Inventor: CONESA CEGARRA, José Carlos, E-28049 Madrid (ES); LUCENA GARCIA, Raquel, E-28049 Madrid (ES); WAHNON BENARROCH, Perla, E-28040 Madrid (ES); PALACIOS CLEMENTE, Pablo, E-28040 Madrid (ES); FERNANDEZ SANCHEZ, Julio Juan, E-28040 Madrid (ES); SANCHEZ NORIEGA, Kefren, E-28040 Madrid (ES); AGUILERA BONET, Irene, E-28040 Madrid (ES)
(74) Representative: Pons Ariño, Angel
(86) International application number: PCT/ES2008/070125
(87) International publication number: WO 2009/010623

(57) **Abstract**

The invention relates to the use, in the manufacturing of materials or devices for photonic applications, of chalcogenide-type compounds having an octahedrally coordinated indium element and wherein a transition element is introduced in octahedral position generating a partially occupied intermediate band separate from those of valence and conduction of the initial semiconductor, according to quantum mechanics calculations. This enables, by absorption of two photons having energy lower than the prohibited bandwidth of the initial semiconductor, a result equivalent to that achieved, without said intermediate band, by the absorption of a higher-energy photon. The use of such a material can thereby improve yield and performance of various photovoltaic, photocatalytic, photoelectrochemical, optoelectronic or photonic conversion devices. Indium sulfide substituted in part with vanadium or titanium is one of the specific materials having these properties that is synthesised according to the invention.

## Description

### FIELD OF THE ART

The present invention relates to chalcogenide compounds which can function as intermediate band materials in photonic applications. Therefore, the invention is found within the sector of new materials, whilst its application is mainly located in the energy sector, and more specifically in the renewable energy sector, such as those which use solar photovoltaic panels or photocatalytic or photoelectrochemical light energy conversion systems; it can also be located, secondarily, in the information technologies sector, within the field of photonics, or the chemical and environmental protection industry, in particular in the applications based on photocatalytic and photoelectrochemical processes.

### STATE OF THE ART

The photovoltaic devices for the use of solar energy most used in the state of the art are based on semiconductor materials whose electronic structure contains a valence band and a conduction band (which, in the absence of defects or doping elements are respectively full and empty of electrons) separated by a range of electron prohibited energies (the "bandgap"). In these materials, the absorption of a photon of electromagnetic radiation with energy the same as or higher than the width of the bandgap produces the passage of an electron from the conduction band (wherein there remains an empty electronic state, called gap) to the valence band, crossing the bandgap; said electron and gap, suitably separated and channelled, can produce current and electric voltage with the end result of the conversion of light energy into electrical energy.

When this phenomenon is desired to be used to convert the sun's radiating energy into electrical energy, the overall efficiency of the energy conversion is limited, due to the spectral characteristics of the solar radiation; the theoretical limit is 40.7 % in said devices (with a single photon absorption material). In practice, the cells that are most widely marketed today, based on silicon as normal semiconductor, reach efficiencies in the order of 20 % or less.

Various schemes have been proposed to increase the limit efficiency. For example, that of multi-junction cells, where the stacking of different elementary cells with different bandgap width leads to an optimized absorption of light with different wavelength in each elementary cell, having reached yields of 39% [M. A. Green; Progr. Photovoltaics 14, 2006, p. 455]; or the indirect conversion through thermal energy using emitters whose radiant spectrum is concentrated in a narrow energy range adapted to the bandgap of a normal photovoltaic element (thermophotovoltaic cells) [T. Coutts; Renew. Sust. Energy Rev. 3, 1999, p. 77].

Another scheme that has been proposed, and which is the basis of the invention presented herein, is based on intermediate band materials [A. Luque, A. Martí; Phys. Rev. Lett. 78, 1977, p. 5014]. In these, in addition to the aforementioned valence and conduction bands, there is another, which does not superimpose in energy with them but instead is energetically positioned between both, and which can be partially occupied by electrons. This intermediate band would then allow, by the absorption of two photons with energies lower than those of the basic bandgap width (the separation between the valence and conduction bands of the material), carry an electron of the valence band to the intermediate band (producing a gap in the valence band) and after the intermediate band to the conduction band, producing the same final result as that which can be achieved by absorbing a single photon of energy higher than the width of the basic bandgap. With said scheme, it is possible to obtain, in principle, a greater total efficiency than that which can be achieved with a normal semiconductor; its limit value is 63.2%, which is reached when the intermediate band is positioned in an optimized position within a basic bandgap which has a width of around 1.93 eV [A. Luque, A. Martí; Phys. Rev. Lett. 78, 1977, p. 5014].

Two generic classes of materials have been proposed for executing the intermediate band: those based on quantum points, which combine two different substances (each with its own crystalline phase) in a composite biphasic material of specific nature [A. Martí et al.; Thin Solid Films 511-512, 2006, p. 638], and the monophase material, formed by a homogeneous compound where the intermediate band appears by virtue of the positions of the electronic levels of any of the elements that form it [A. Luque, A. Martí; Progr. Photovoltaics 9, 2001, p. 73].

There is very little biography which has considered the photovoltaic use of monophasic intermediate band materials such as those mentioned in the previous paragraph. On theoretical bases, gallium arsenide, phosphide and nitride have been proposed, with the substitution of one of its atoms by transition elements such as Ti and Cr [a) P. Wahnón, C. Tablero; Phys. Rev. B 65, 2002, 165115. b) P. Wahnón et al.; J. Mater. Sci. 40, 2005, p. 1383-1386. c) P. Palacios et al.; Phys. Rev. B 73, 2006, 085206. d) C. Tablero; Solar In. Mat. Solar Cells 90, 2006, p. 1734], although the feasibility of these systems is hindered by formation energy balance of such a type of compound, which is quite unfavourable [P. Palacios et al.; J. Chem. Phys. 124, 2006, 014711] in accordance with the already known fact that the Ga-As-Ti phase diagram [Q. Han, R. Schmid-Fetzer; Metall 46, 1992, p. 45] does not include any ternary compound. Likewise, on theoretical bases, the chalcopyrite CuGaS₂ substituted with Ti has been proposed, in this case the energy balance being less unfavourable [a) P. Palacios et al.; Phys. Sta. Sol. (a) 203, 2006, p. 1395-1401. b) P. Palacios et al.; Thin Solid Films 515, 2007, p. 6280], and also type II-VI semiconductor doped with transition metals [C. Tablero; Solar In. Mat. Solar Cells 90, 2006, p. 588] or CuAlO₂ doped with Cd [M.V. Lalić et al.; Brazilian J. Phys. 34 2B, 2004, p. 611], although in these last cases the feasibility has not been evaluated. On the other hand, it has been proposed that zinc and manganese telluride doped with oxygen [K.M. Yu et al.; J. Appl. Phys. 95, 2004, p. 6232] or certain type III-V materials (Ga,As)(N,P) [K.M. Yu et al.; Appl. Phys. Lett. 88 (2006) 092110], both compounds with tetrahedral coordination structures which have been prepared experimentally, may have intermediate band characteristics; but their band structures have not been clearly determined. In none of these cases has an intermediate band photovoltaic cell been built based on the corresponding compound.

Finally, we should indicate that a good number of additional cases are known wherein the addition of a transition metal to a semiconductor with a bandgap of suitable width introduced in it, according to quantum calculations made and their correlation with experimental data, new electronic levels with well-defined band characteristics, but without said band being separated in energy from those of valence and/or conduction, so that the suitable requirements are not present to obtain a good photovoltaic intermediate band functioning; this is the case, for example, of several materials which include manganese (or other neighbouring atoms thereof in the periodic table) in type III-V semiconductors or chalcogenide, and which are currently highly studied for their possible use in spintronic devices. The solubility of said transition metal in these compounds is fairly low, which undoubtedly has to do with the exclusively tetrahedral coordination provided thereby.

On the other hand, as regards the compounds proposed in this patent as intermediate band materials, and which are **characterized in that** they include the element indium with octahedral coordination, other authors have performed and verified the insertion of a transition element of the first series, with said coordination, in some compounds of that type. For example, systems have been reported with Co and Cr inserted in MgIn₂S₄, CdIn₂S₄ and In₂S₃ [a) S.-J. Lee et al.; J. Mater. Res. 18, 2003, p. 733-736; b) D. Fiorani, S. Viticoli; Solid St. Comm. 32, 1979, p. 889-892; c) V. Schellenschläger, H. D. Lutz; Mat. Res. Bull. 35, 2000, p. 567]; however, no defined phase or compound is known in the bibliography which result from the incorporation of the elements Ti or V in any of these materials. We should also mention that inverse thiospinels of In and the metals Cr, Mn, Fe, Co and Ni are known, wherein they are present with octahedral coordination (see, for example H. D. Lutz et al.; J. Raman Spect. 20, 1989, p. 99-103, and other works by the same group of authors). But, to date, none of the materials thus prepared has determined its electron band structure, nor has it considered its photovoltaic, or photonic application, in general.

### BRIEF DESCRIPTION

One aspect of the invention is the use in the manufacturing of materials or devices for photonic applications of chalcogenides, hereinafter chalcogenides of the invention, which comprise In in octahedral position and wherein metal atoms of the compound in octahedral position have been substituted in part by a transition element which in the resulting material has its electron valence layer partially occupied and generates an intermediate band.

A preferred aspect of the invention is the use in the manufacturing of materials or devices for photonic applications, of the chalcogenides of the invention wherein the chalcogenide is a sulfide.

Another aspect of the invention is the indium sulphide material, hereinafter modified indium sulfide of the invention, **characterized in that** the indium atoms of the compound in octahedral position have been substituted in part by titanium atoms or by vanadium atoms.

Another more preferred aspect of the invention is the use in the manufacturing of materials or devices for photonic applications of the modified indium sulfide of the invention.

A preferred aspect of the invention consists of the use in photonic applications, as intermediate band materials, of chalcogenides which comprise indium in octahedral position, and wherein between 15 and 0.1 % of the metal atoms of the compound in octahedral position have been substituted by a transition element.

Another preferred aspect of the invention is the use of the chalcogenides of the invention in solar photovoltaic cells.

Another preferred aspect of the invention is the use of the chalcogenides of the invention in chemical processes of photocatalytic, photoelectrochemical or photosynthetic type, based on said absorption process of two low energy photons to produce higher-energy gap-electron separation.

Another preferred aspect of the invention is the use of the chalcogenides of the invention in low energy photon detectors.

Another preferred aspect of the invention is the use of the chalcogenides of the invention in photonic conversion processes.

Another aspect of the invention are solar photovoltaic cells wherein the chalcogenides of the invention are used as light absorbents.

### DETAILED DESCRIPTION OF THE INVENTION

The present invention is based on the fact, observed by the inventors from electronic structure calculations (see Example 1 explained below), that the substitution of In atoms in octahedral coordination by atoms of certain transition metals in indium chalcogenides, or mixed of In with another metal, leads to the formation of an intermediate band material with good stability and the suitable characteristics for photonic applications, such as, for example in a photovoltaic cell.

The following are defined in this invention:
- Chalcogenides as those chemical compounds resulting from the combination of one or several chalcogens (chemical elements of group 16 or VIA of the periodic table of the elements) with one or several metals.
- Photonic applications such as those uses of the material based on photon absorption from an incident beam, or/and the emission of photons, in a manner coupled to an electronic transition which occurs in said material.

The indium chalcogenides, and the mixed chalcogenides of In with other metals such as Zn, Cd, Mg or Ga, are semiconductors with a mixed covalent-polar character which facilitates the substitution of one of their electropositive elements (In, Mg, Zn, Ga, etc) by a transition metal. This substitution is further favoured by an octahedral coordination of said electropositive element. The transition metal, on being introduced substitutionally, will provide partially occupied electronic levels, with type d atomic symmetry; the characteristics of said levels make the orbital overlapping thereof with that of the neighbouring atoms small or moderate, so that the state band generated by said levels will interact relatively little with the valence and conduction bands and it can thus be separated from them with greater ease. The inventors have observed that this type of substitution in chalcogenide compounds of In, or mixed of In with another metal, may be thermodynamically favourable and generate an intermediate band in the material which provides it with appropriate characteristics for various photonic applications.

Thus, an aspect of the invention is the use in the manufacturing of materials or devices for photonic applications of chalcogenides, hereinafter chalcogenides of the invention, which comprise In in octahedral position and wherein metal atoms of the compound in octahedral position have been substituted in part by a transition element which, in the resulting material, has its electron valence layer partially occupied and generates an intermediate band of the type described in this invention. In addition to Indium, and without this limiting the scope of the invention, there may be other metal elements in the material in octahedral position which can be substituted, such as, for example, calcium or chromium.

A preferred aspect of the invention is the use in the manufacturing of materials or devices for photonic applications, of the chalcogenides of the invention wherein the chalcogenide is a sulfide.

Trivalent indium sulfide, In₂S₃, is a known compound, with a spinel-type structure (analogue to the natural material spinel, MgAl₂O₄) wherein most of the n atoms have octahedral coordination. Said compound can be prepared using methods such as those of direct synthesis from the elements that form it, the evaporation of said elements (or of compounds thereof) or the deposition thereof in a chemical or electrochemical bath. This compound is used today in photovoltaic cells; in particular, thin sheets of In₂S₃, prepared by evaporation or chemical deposition, are frequently used as window layers (not radiation absorbent) in thin layer photovoltaic devices wherein the absorbent material is a copper and gallium and/or indium sulfide or/and selenide with chalcopyrite structure. It can be expected that a material based on In₂S₃ will be easily integrated in photovoltaic devices of said type. We should mention here that in the chalcopyrite structure (different from those of the chalcogenides the invention relates to), derived from the cubic zinc sulfide ZnS substituting therein every two atoms of Zn by a monovalent metal element and a trivalent one in an array equal to that of the natural mineral chalcopyrite (CuFeS₂), all elements that compose it have tetrahedral configuration, less favourable for the insertion of transition elements. As described below (Example 2), in this invention indium sulfide was prepared in the form of polycrystalline powder by a solvothermal method from indium chloride and a source of sulfide, and it was modified by the method of including in the preparation mixture a chloride of the corresponding transition metal, so that part of its octahedrally coordinated indium atoms were substituted by titanium or vanadium atoms. We should mention here that the In₂S₃ preparation substituted with vanadium or titanium has not been previously reported in the bibliography. For said compositions it was shown, by quantum calculations, that an intermediate band electronic structure could be obtained. The method also permits varying the degree of electron occupation of said intermediate band altering the state of oxidation of the transition element, either by the change of the initial stoichiometry thereof or by addition of another metal element of different valence.

Therefore, another aspect of the invention is the indium sulfide, hereinafter modified indium sulfide of the invention, **characterized in that** the indium atoms of the compound in octahedral position have been substituted in part by titanium atoms or by vanadium atoms.

Another more preferred aspect of the invention is the use in the manufacturing of materials or devices for photonic applications of the modified indium sulfide of the invention.

The intermediate band generated by the substitution of the atoms in octahedral positions in the chalcogenides of the invention should not be superimposed with the valence or conduction bands. Its width must therefore be moderate, of no more than approx. 0.5 eV in total; this limits the quantity of metal that should be introduced, and according to this it is calculated that there must not be over 15% substitution in the octahedral positions. On the other hand, general theoretical estimates [A. Luque et al.; Physica B Cond. Matter 382, 2006, p. 320] indicate that the new energy levels thus introduced in the bandgap will have a band state delocation, and therefore important problems of non-radiative recombination shall be avoided (as is desirable in the type of material the invention relates to), if the concentration of transition atoms introduced is over 0.1%.

Therefore, a preferred aspect of the invention consists of the use in photonic applications, as intermediate band materials, of chalcogenides which comprise indium in octahedral position, and wherein between 15 and 0.1 % of the metal atoms of the compound in octahedral position have been substituted by a transition element.

Another preferred aspect of the invention is the use of the chalcogenides of the invention in solar photovoltaic cells. In this case, the chalcogenide plays the role of light absorber and gap and electron generators which are carried to the outside to use the electrical energy. In this process, and thanks to the existence of the intermediate band, two photons can be used with energy lower than that of the overall bandgap to achieve with them the same electron excitation result of the valence band to the conduction band which in the absence of the intermediate band could be achieved just with photons with the same or higher energy as that of said bandgap.

Another preferred aspect of the invention is the use of the chalcogenides of the invention in chemical processes of photocatalytic, photoelectrochemical or photosynthetic type, being based on the same said absorption process of two low energy photons to produce higher-energy gap-electron separation.

Another preferred aspect of the invention is the use of the chalcogenides of the invention in low energy photon detectors, again based on the intervention of the intermediate band.

Another preferred aspect of the invention is the use of the chalcogenides of the invention as photonic energy converters in up-conversion processes, making it possible to absorb low energy photons to emit higher-energy photons, or down-conversion, absorbing high-energy photons to emit two lower-energy photons.

### DESCRIPTION OF THE FIGURES

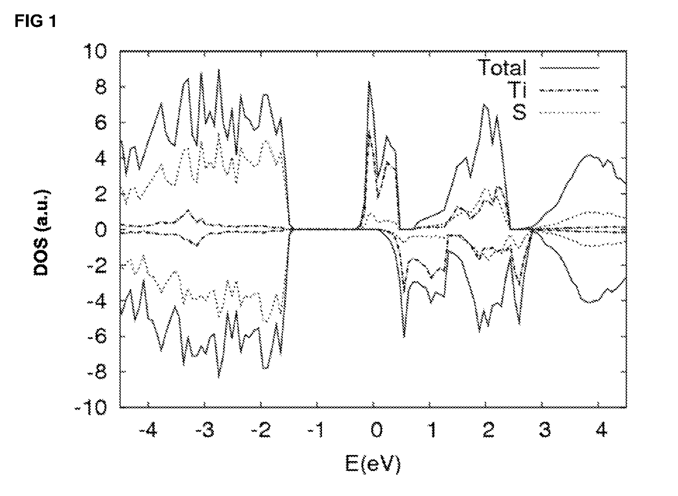

Figure 1. Result of a spin-polarized DFT electronic structure calculation (GGA theory level) performed by the authors of this invention for a MgIn₂S₄ structure (spinel-type) wherein part of the In (octahedral) is regularly substituted by Ti to give a final atomic composition Mg₂TiIn₃S₈ (primitive cell content used in the calculation). Density of state curves (DOS) are represented for the majority spin electrons (placed in the positive ordinate of the graphic) and minority spin electrons (placed in the negative part for easier comparison), indicating both total densities of states and those projected on the atoms of metals Ti and S. The energy zeros in the x-axis corresponds to the Fermi E_{F} level: the states with energy lower than E_{F} are occupied by electrons, those of greatest energy are unoccupied.

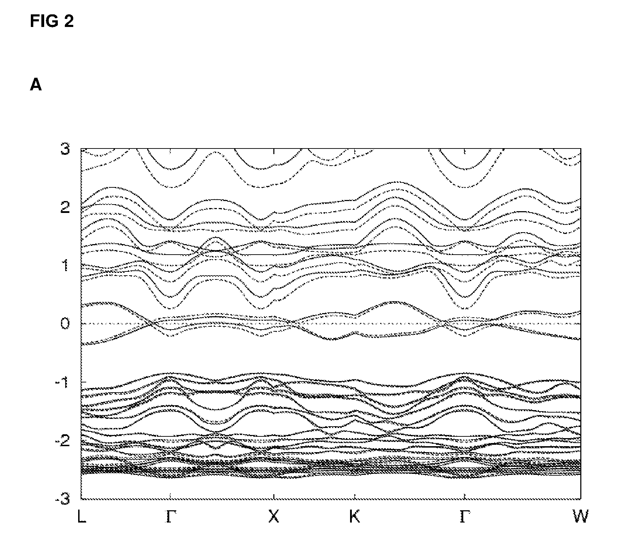

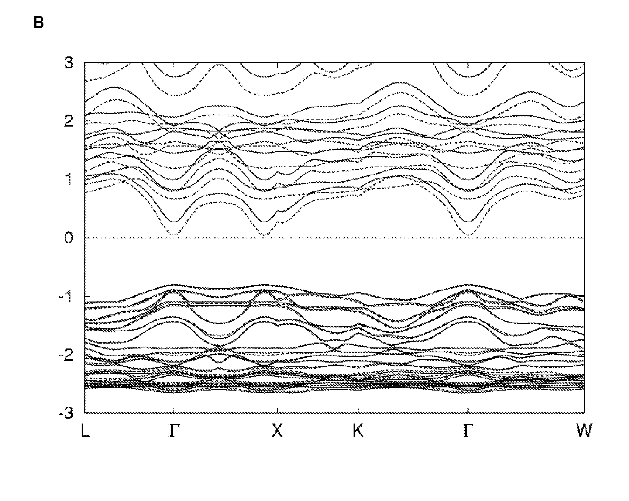

Figure 2. Result of a spin-polarized DFT electronic structure calculation performed by the authors of this invention for a CuGaS₂ structure (of chalcopyrite type) wherein part of the In (octahedral) is regularly substituted by Ti to give a final atomic composition Cu₄TiGa₃S₈. The band dispersion curves are represented throughout lines which connect points of high symmetry of the inverse space of the crystalline structure. The energy zero in ordinates corresponds to the Fermi E_{F} level, which separates the occupied states (with energies lower than E_{F}) from the unoccupied states (with higher energies). Part A of the figure represents the electronic states with majority spin, part B of minority spin. The results obtained with the GGA theory level are compared (standard), indicated with broken lines, with those of level EXX, more advanced and accurate, indicated with solid line. It can be observed how the levels of the intermediate band, constituted by majority spin levels which intersect with the Fermi level, and which in the result of the GGA theory level are superimposed in energy with that of the conduction band, appear clearly separated from it in the result of the more exact EXX calculation.

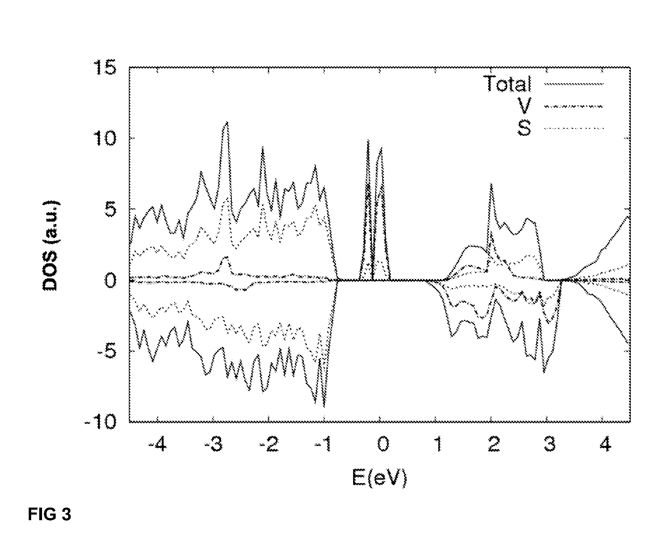

Figure 3. Result of a spin-polarized DFT electronic structure calculation (GGA theory level) performed by the authors of this invention for a MgIn₂S₄ structure (of spinel type) wherein part of the In (octahedral) is regularly substituted by V to give a final atomic composition Mg₂VIn₃S₈. Explanation of curves and axes analogous to those of Figure 1.

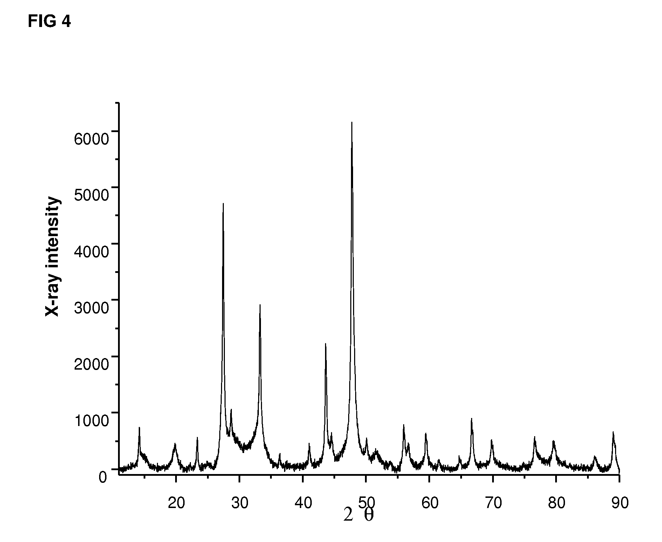

Figure 4. X-ray diffraction diagram (measured with copper Kα radiation) registered for the material In₂S₃ in powder substituted in part with vanadium which has been obtained by the authors of the invention by solvothermal method.

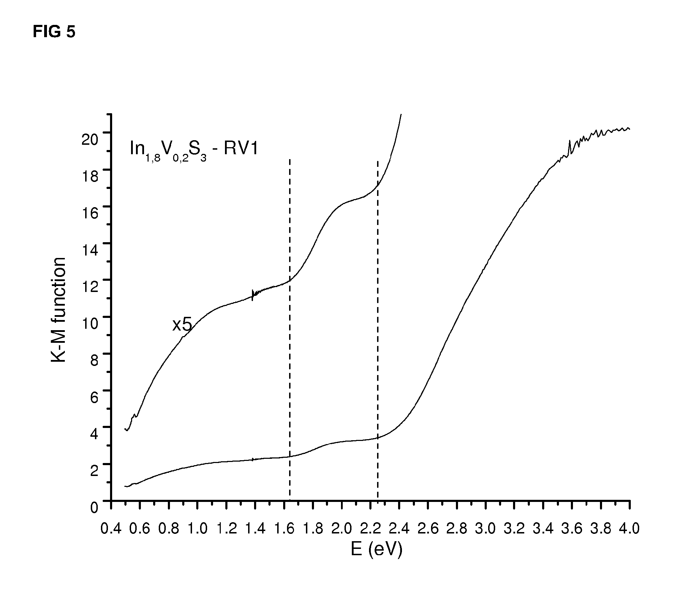

Figure 5. Light absorption spectrum in the UV-vis-NIR range (obtained by a Kubelka-Munk transformation of the diffuse reflectance spectrum) registered for the In₂S₃ material in powder substituted in part with vanadium which has been obtained by the authors of this invention by the solvothermal method.

### EMBODIMENTS OF THE INVENTION

### Example 1 - Determination of the intermediate band electronic structure in sulfides with spinel-type structure which comprise indium in octahedral position and wherein part thereof has been substituted by titanium or vanadium.

The authors of this invention performed quantum mechanics calculations using the standard methodology of the density functional theory (DFT), in its generalized gradient approximation (GGA). For this, the VASP program was used [G. Kresse and J. Hafner, Phys. Rev. B 47 (1993) RC558; G. Kresse and J. Furthmüller, Phys. Rev. B 54 (1996) 11169; G. Kresse and J. Joubert, Phys. Rev. B 59 (1999) 1758], based on an expansion of the electronic functions in flat waves and representing the internal elections with PAW potentials. A calculation was made on the direct spinel structure of the compound MgIn₂S₄ (which has an experimental bandgap width of approx. 2.4 eV and constitutes for the purposes of this invention a satisfactory model of the In chalcogenides with octahedral coordination), substituting therein in ordered form 25% of the In atoms by Ti (a substitution in each primitive cell, the total content of which corresponds to the formula Mg₂In₄S₈). The result of said calculation shows, as indicate in Fig. 1, that after that substitution levels appear in the bandgap associated to titanium, which form a partially occupied band and with moderate width. It should be mentioned that analogous calculations performed on structures with greater primitive cell size, and less substitution percentage of In by Ti (for example, for Mg₄TiIn₇S₁₆ compositions), give an appreciably similar result although with less magnitude and width in the new levels due to Ti.

Said new levels appear, in the result reflected in Fig. 1, partially superimposed to those of the conduction band of the initial semiconductor, which means it would apparently not satisfy the desired separation of said levels with respect to the valence and conduction bands; but it should be borne in mind that the standard DFT theory, even in its GGA category used here, always underestimates the width of the bandgap of the semiconductors (and, in general, the energy separation between occupied and empty levels); said systemic error, however, does not affect the separation between the different occupied levels. It can be assumed that, in a calculation which was not affected by said underestimation, the new band which appears in the bandgap after the incorporation of titanium will maintain, with respect to the valence band, the same energy separation as that observed in the calculation made, whilst the conduction band would appear with higher energy and, therefore, it would no longer be superimposed with the intermediate, which would therefore have the desired characteristic of not being superimposed on the conduction band.

A calculation of greater accuracy in this respect could be obtained, within the DFT formalism, using the most recent approximation of "exact exchange" (EXX), which has been implemented by authors of this invention in the solids DFT calculation program called SIESTA [J.J. Fernández, C. Tablero, P. Wahnón; Comput. Mat. Sc. 28, 2003, 274]. The authors of the invention have performed calculations of this type for other sulphide-type materials and simpler structure (specifically, CuGaS₂ chalcopyrites, with tetrahedral coordination) wherein the trivalent element is substituted in part by Ti. In said materials the standard DFT calculation predicts a superposition between the intermediate band and the conduction band, whilst a more exact calculation DFT-EXX (which computationally is very costly) predicts, as shown in Fig. 2, a well-insulated intermediate band. It can be supposed that this same situation arises in the aforementioned compound MgIn₂S₄ when indium is substituted in it by titanium, although the DFT-EXX method has not been applied to this compound as the calculation, as has been stated, is too costly.

Similar DFT calculations to those mentioned demonstrate the possibility of obtaining an intermediate band similar to that of the first case cited making the substitution with vanadium instead of with titanium (Fig. 3). Other systems wherein the possibility of obtaining intermediate band materials has been verified, by DFT calculations, when the octahedral In is substituted in part by Ti or V are In₂S₃ (also with spinel type structure, and a bandgap width of ≈2.0 eV) or ZnIn₂S₄ (with layers structure and bandgap width of ≈2.3 eV). In all of them, the results of the calculations (not shown here) give intermediate band situations similar to those already described for the same substituting element. The variety of sulphide-type semiconductors of an octahedral cation wherein an intermediate band of the desired type could potentially be obtained by substitution with a transition element is, therefore, probably fairly extensive.

The feasibility of preparing materials such as those studied with these calculations is supported by the estimations, given by these same calculations, of the energy necessary to introduce one of these transition metals in octahedral sulphides of those considered here. For example, it is possible to calculate the energy corresponding to this process:

7 In₂S₃ + Ti₂S₃→ Ti₂In₁₄S₂₄

where a product is considered wherein, within the spinel-type structure of the In₂S₃, titanium atoms are positioned, regularly distributed, in indium positions which have octahedral coordination. Said energy is, according to the DFT calculations made, in the order of +0.06 eV for each titanium atom. An analogous calculation for the substitution of octahedral indium in In₂S₃ by vanadium gives a balance of +0.11 eV per vanadium atom. Despite these energies being of positive sign (which would imply a balance which is somewhat unfavourable for the process), its effect is more than compensated for, in the configuration of the free energy of the total reaction (which is the magnitude which actually determines the process feasibility), by the contribution of the disorder entropy due to the multiplicity of configurations whereby the titanium may partially substitute indium. Indeed, as shown in previous calculations made in analogous systems [P. Palacios et al.; J. Chem. Phys. 124, 2006, 014711] the magnitude of said contribution, of negative sign, is higher than 0.1 eV/substituting atom for typical preparations of this type of compounds (600 K or higher) and substitution concentrations in the range 0.5%-15%; said concentration is, therefore, that which in this invention is considered more appropriate for the formation of efficient intermediate band cells.

### Example 2 - Preparation of indium sulfide substituted in part with vanadium

As demonstration that materials of this type can be obtained with an electronic structure in accordance with that predicted by calculations, we should indicate that the preparation of an indium sulphide substituted by vanadium was undertaken. A solvothermal method was used, verifying, in first place, that In₂S₃ could be obtained, using the reaction

2 InCl₃ + 3 Na₂S → In₂S₃ + 6 NaCl

The reaction was carried out by heating in an autoclave with Teflon coating an aqueous solution of both reagents during 16 h at temperatures of up to 150 ºC. The characteristics (x-ray diffraction diagram, light absorption spectrum) of the solid product obtained in the form of yellowish polycrystalline powder indicated that this material was effectively achieved. Next, the same reaction was carried out by substituting 10% of InCl₃ by VCl₃. In this case, the solution was prepared in the absence of air, using a water-ethylene glycol mixture as solvent (in 1:19 proportion by weight), and it was treated in a thick-wall glass vial at 150 ºC for 18 h. A powdery green-grey product was achieved which, once washed and dried, had the X-ray diffractogram shown in Fig. 4. In it, all the peaks observed (except that which appears at 2θ ≈ 20º, which is due to the contribution of the slide) correctly correspond in position and intensity with those expected for the spinel-type phase of In₂S₃ (in its cubic version, with disordered cationic vacancies) with a network constant= 10.76 Å; that no other peaks appear indicate that the vanadium, whose presence in the material was verified by chemical analysis (proportion In:V=0.15:1.85), has been incorporated in said phase.

Furthermore, the UV-Vis-NIR diffuse reflectance spectrum has been obtained for this material which, once transformed on a proportional scale to the absorbance by the Kubelka-Munk equation, gave the curve shown in Fig. 5. In it, it can be observed, superimposed to the absorption leap which starts at approximately 2.2 eV and which corresponds to the bandgap of pure In₂S₃, a leap at lower energy which is started at approx. 1.7 eV and which, in light of Fig. 3, can be assigned to the transition between the occupied states of the intermediate band and the empty states of the conduction band. We can also observe in the spectrum an absorption from approx. 0.5 eV which is not present in the spectrum of the pure In₂S₃ spectrum measured analogously and which can be assigned to the transitions from the valence band to the empty states of the intermediate band. The fact that the sum of both threshold energies (1.7 and 0.5 eV) is equivalent to the threshold of the main leap to 2.2 eV supports this interpretation.

## Claims

1. Use of chalcogenides which comprise In atoms in octahedral positions, and wherein metal atoms of the compound which are in octahedral position have been substituted in part by a transition element to generate a partially occupied intermediate band within the bandgap, in the manufacturing of materials or devices for photonic applications based on the existence of said intermediate band.

2. Use in the manufacturing of materials or devices for photonic applications of the compounds described in claim 1, **characterized in that** the chalcogenides are sulfides.

3. Modified indium sulfide material, **characterized in that** the indium atoms of the compound In₂S₃ found in octahedral position have been substituted in part by Ti atoms or V atoms.

4. Use of the material described in claim 3, in the manufacturing of materials or devices for photonic applications.

5. Use in the manufacturing of materials or devices for photonic applications of the chalcogenide compounds mentioned in claims 1-4, wherein between 15 and 0.1% of the metal atoms of the compound in octahedral position have been substituted by a transition element.

6. Use of the chalcogenide compounds mentioned in claims 1-5 in solar photovoltaic cells.

7. Use of the chalcogenide compounds mentioned in claims 1-5 in low energy photon detectors.

8. Use of the chalcogenide compounds mentioned in claims 1-5 in photocatalytic, photosynthetic or photoelectrochemical processes.

9. Use of the chalcogenide compounds mentioned in claims 1-5 in photonic conversion processes.

10. Solar photovoltaic cells **characterized in that** they use the materials mentioned in claims 1-5 as light absorbents.
